Europäisches Patentamt

European Patent Office

Office européen des brevets

(11) Numéro de publication: **0 201 396**

**A1**

(12) **DEMANDE DE BREVET EUROPEEN**

(21) Numéro de dépôt: **86400872.7**

(22) Date de dépôt: **22.04.86**

(51) Int. Cl.⁴: **H04N 1/12 , H01L 25/04**

(30) Priorité: **30.04.85 FR 8506570**

(43) Date de publication de la demande:
**17.12.86 Bulletin 86/46**

(84) Etats contractants désignés:
**DE GB IT**

(71) Demandeur: **THOMSON-CSF**
**173, Boulevard Haussmann**
**F-75379 Paris Cedex 08(FR)**

(72) Inventeur: **Arques, Marc**
**c/o Thomson-CSF SCPI 19, avenue de**
**Messine**
**F-75008 Paris(FR)**
Inventeur: **Moy, Jean-Pierre**
**c/o Thomson-CSF SCPI 19, avenue de**
**Messine**
**F-75008 Paris(FR)**

(74) Mandataire: **Mayeux, Michèle et al**
**THOMSON-CSF SCPI 19, avenue de Messine**
**F-75008 Paris(FR)**

(54) **Dispositif d'aboutement optique de détecteurs photosensibles.**

(57) Le dispositif selon l'invention utilise un système optique comportant deux prismes (4, 5), accolés par une face semi-réfléchissante (6). Les détecteurs (d) sont disposés sur deux faces à angle droit, appartenant chacune à un prisme. La disposition des barrettes est telle qu'elles sont aussi proches que possible l'une de l'autre et que la jonction de deux barrettes sur l'une des deux faces ne correspond pas à la jonction de deux barrettes sur l'autre face. Des moyens assurent la sommation des informations en provenance de deux détecteurs $(d_3, d_4)$, situés sur chacune des deux faces, et ayant reçu le même signal.

FIG_4

## DISPOSITIF D'ABOUTEMENT OPTIQUE DE DETECTEURS PHOTOSENSIBLES

La présente invention concerne un dispositif d'aboutement optique de détecteurs photosensibles, disposés sous forme de barrettes.

Dans certains domaines, tels que par exemple la prise de vues de la terre par satellite, on cherche à réaliser des alignements d'un très grand nombre de détecteurs photosensibles, par exemple 10 000 détecteurs. Les détecteurs doivent être positionnés de façon très précise, avec un pas de quelques dizaines de micromètres par exemple. Pour réaliser ces lignes de détecteurs, on dispose de barrettes comportant un nombre limité de détecteurs qui est d'environ 2000 dans le cas de détecteurs en silicium et de quelques centaines seulement dans le cas de détecteurs réalisés sur des semi-conducteurs ternaires ou quaternaires, de formule par exemple Hg Cd Te ou Ga In As P.

On sait réaliser ces lignes de détecteurs en mettant bout à bout un nombre suffisant de barrettes.

Il est connu dans l'art antérieur de réaliser cet aboutement de façon optique ou mécanique.

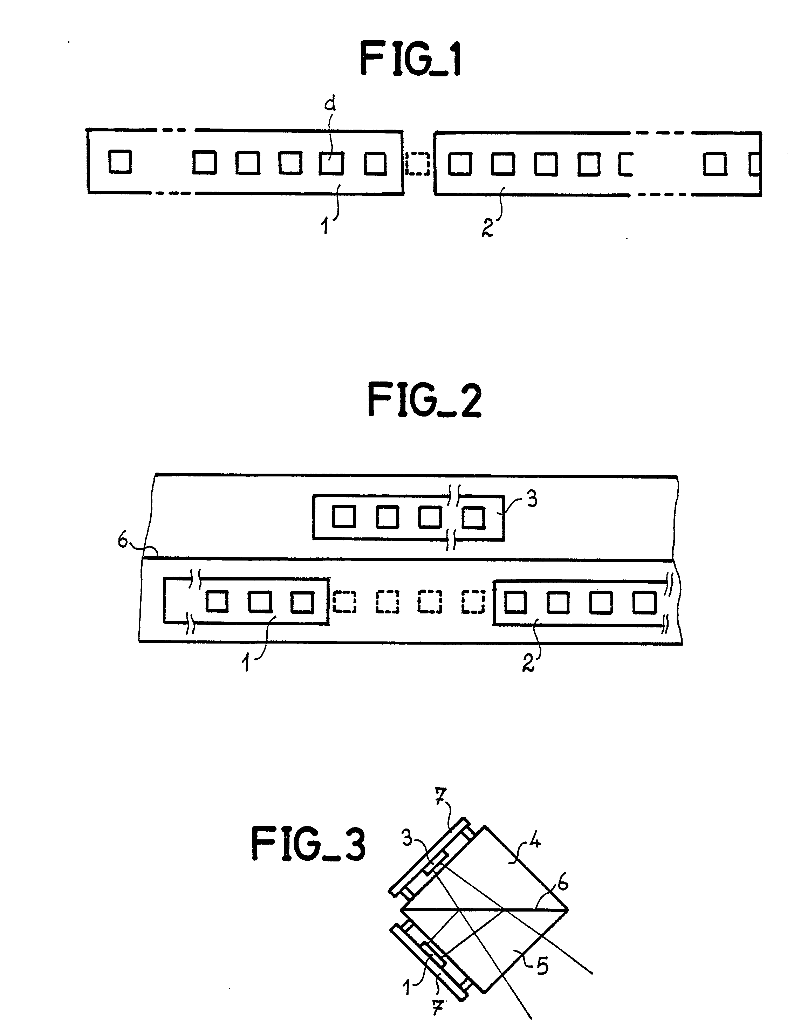

L'aboutement mécanique consiste à coller des barrettes sur un substrat en respectant le pas des détecteurs comme cela est illustré sur la figure 1.

Sur la figure 1, deux barrettes 1 et 2 sont mises bout à bout. Elles portent des détecteurs référencés d.

L'aboutement mécanique présente notamment les inconvénients suivants:

-sa réalisation est difficile car il nécessite un positionnement précis des barrettes sur leur support, en ce qui concerne notamment leur alignement et le respect du pas entre détecteurs de deux barrettes voisines;

-à la jonction de deux barrettes, il est fréquent qu'il manque au moins un détecteur et que les détecteurs voisins des bords soient détériorés;

-enfin lorsqu'une barrette porte un détecteur qui ne fonctionne pas, le rapport signal sur bruit est nul pour ce détecteur.

L'aboutement optique, tel qu'il est connu de l'art antérieur, demande l'utilisation d'un système optique constitué de deux prismes indentiques accolés par une face semi-réfléchissante.

Ce système est dérivé du "cube de Lummer" bien connu qui est utilisé pour séparer un faisceau convergent en deux faisceaux, sans introduire d'astigmatisme. Dans le cas de l'aboutement optique, le système optique utilisé n'est pas un cube mais un parallélépipède, car il faut pouvoir aligner sur deux de ses faces les barrettes de détecteurs.

Sur la figure 3, on a représenté une vue de côté de ce système optique avec les deux prismes 4 et 5, accolés par leur face semi-réfléchissante 6. Les barrettes de détecteurs 1 et 3 sont disposées sur deux faces à angle droit appartenant chacune à un prisme différent. Elles sont portées par un support 7.

Sur la figure 2, on a représenté ce système optique vu de face. Sur cette vue, on a représenté les deux faces des prismes portant des barrettes référencées 1, 2, 3.

Comme cela est illustré sur la figure 3 le système optique dédouble l'image à analyser, grâce à sa face semi-réfléchissante 6.

Les barrettes portées par l'une des faces du système reçoivent l'image après réflexion sur la face semi-réfléchissante 6, et les barrettes portées par l'autre face du système reçoivent la même image transmise par la face semi-réfléchissante 6.

La figure 2 montre comment sont disposées les barrettes 1, 2, 3...

L'une des faces porte les barrettes de rang pair et l'autre celles de rang impair. Les barrettes sont disposées de façon symétrique par rapport à la face semi-réfléchissante 6.

Comme cela est illustré sur la figure 2, entre deux barrettes disposées sur une même face, on laisse un intervalle correspondant sensiblement à une barrette disposée sur l'autre face. Ainsi, sur la figure 2, entre les barrettes 1 et 2 on laisse un intervalle correspondant à la barrette 3 portée par l'autre face. Dans l'exemple choisi, les barrettes 1 et 2 reçoivent l'image par réflexion et la barrette 3 reçoit l'image par transmission. L'aboutement des barrettes est ainsi réalisé de façon optique.

L'aboutement optique connu selon l'art antérieur présente essentiellement l'inconvénient d'avoir un faible rapport signal sur bruit à cause de la couche semi-réfléchissante.

La perte de luminosité causée par cette couche est au moins égale à un facteur 2. En fait cette perte est souvent beaucop plus importante et égale à un facteur 3 à 4.

En effet, on souhaite généralement faire de la radiométrie, c'est-à-dire connaître avec précision les caractéristiques de réflectivité spectrale de l'imagine reçue. Les détecteurs fonctionnent alors dans un domaine spectral assez large et avec une polarisation incidente variable.

Pour que les coefficients de réflexion et de transmission soient égaux, même avec une polarisation incidente variable, on est conduit à utiliser une couche semi-réfléchissante métallique, à base de nickel ou de chrome par exemple. Le bilan optique de ces couches est par exemple le suivant: 30% du signal est transmis, 30% du signal est réfléchi et 40% du signal est absorbé.

Par rapport à l'aboutement mécanique pour lequel on suppose que le rapport signal sur bruit égale 1, le rapport signal sur bruit dans le cas de l'aboutement optique, pour une même technologie de détecteurs, n'est que de 0,3 environ.

Comme dans le cas de l'aboutement mécanique, l'aboutement optique selon l'art antérieur traduit par un rapport signal sur bruit nul la présence d'un détecteur ne fonctionnant pas sur une barrette.

Par rapport à l'aboutement mécanique, l'aboutement optique selon l'art antérieur ne cause généralement pas de perturbation à la jonction des barrettes. Il n'y a généralement pas de points manquants à la jonction des barrettes, et les points voisins des bords des barrettes ne sont pas détériorés.

La présente invention concerne un dispositif d'aboutement optique de détecteurs photosensible qui, tout en conservant les avantages essentiels du dispositif d'aboutement optique connu de l'art antérieur, présente des avantages supplémentaires en ce qui concerne notamment le rapport signal sur bruit qui est beaucoup plus élevé puisqu'il passe de 0,3 à 0,7 environ; en ce qui concerne aussi l'obtention dans le cas d'un détecteur ne fonctionnant pas d'un rapport signal sur bruit égal à 0,5 environ. Ainsi un point mort accidentel sur une barrette ne se traduit pas par un point aveugle sur la ligne de détecteurs reconstituée, mais seulement par un point de plus faible rapport signal sur bruit, ceci à condition d'avoir repéré la présence de ce détecteur mort. Cette correction est particulièrement intéressante dans le cas de détecteurs infra-rouge qui utilisent des semi-conducteurs où les défauts ponctuels sont plus fréquents que dans le silicium, et pour lesquels le rendement de fabrication de barrettes est très faible.

De plus, le dispositif d'aboutement optique selon l'invention présente une redondance de détecteurs qui lors d'application spatiales est un atout.

La présente invention concerne un dispositif d'aboutement optique de détecteurs photosensibles, disposés sous forme de barrettes, comportant deux prismes accolés par une face semi-réfléchissante, les détecteurs étant disposés sur deux faces à angles droit, appartenant chacune à un prisme, caractérisé en ce que:

-il y a au moins un alignement de barrettes sur chacune des faces, ces barrettes étant aussi proches que possible l'une de l'autre et disposées de façon telle que la jonction de deux barrettes sur l'une des faces ne corresponde pas à la jonction de deux barrettes sur l'autre face;

-des moyens assurent la sommation des informations en provenance de deux détecteurs, situés sur chacune des deux faces, et ayant reçu le même signal.

D'autres objets, caractéristiques et résultats de l'invention ressortiront de la description suivante, donnée à titre d'exemple non limitatif et illustrée par les figures annexées qui représentent:

-la figure 1 un schéma illustrant un dispositif d'aboutement mécanique selon l'art antérieur;

-les figures 2 et 3, des schémas illustrant un dispositif d'aboutement optique selon l'art antérieur;

-la figure 4, un schéma illustrant un dispositif d'aboutement optique selon l'invention;

-la figure 5, un tableau comparatif des différents dispositifs d'aboutement dont il est question dans ce brevet en ce qui concerne le rapport signal sur bruit.

Sur les différents figures, les mêmes repères désignent les mêmes éléments, mais, pour des raisons de clarté, les cotes et proportions des divers éléments ne sont pas respectées.

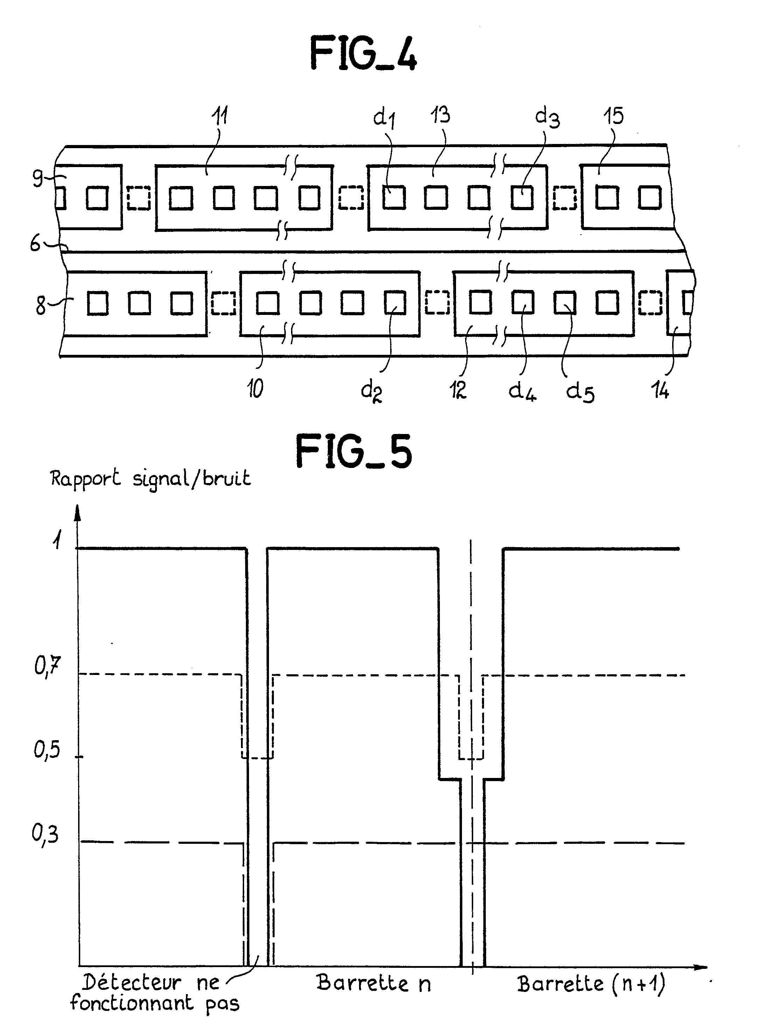

La figure 4 illustre le dispositif d'aboutement optique selon l'invention.

Comme dans le dispositif d'aboutement optique connu, on utilise toujours deux prismes accolés par une face semi-réfléchissante. Les barrettes de détecteurs sont toujours disposées sur deux faces à angle droit, appartenant chacune à un prisme, mais la disposition des barrettes est différente comme cela est illustré sur la figure 4.

Selon l'invention, les barrettes sont aussi proches que possible les unes des autres. Elles sont positionnées de façon telle que la jonction de deux barrettes sur l'une des faces du prisme ne corresponde pas à la jonction de deux barrettes sur l'autre face.

Sur la figure 4, à titre d'exemple il y a entre deux barrettes consécutives portées par une même face un espacement correspondant à un seul détecteur représenté en pointillés.

Comme dans l'art antérieur, les barrettes sont disposées de façon symétrique par rapport à la face semi-réfléchissante 6.

Chaque détecteur d fournit une quantité de charges proportionnelle à l'éclairement reçu. Des moyens de lecture permettent de lire séquentiellement chaque détecteur. Ces moyens sont généralement constitués par un dispositif à transfert de charge comportant un multiplexeur.

Selon l'invention, des moyens assurent la sommation des informations en provenance de deux détecteurs, situés sur chacune des deux faces, et ayant reçu le même signal.

Les signaux issus de deux détecteurs qui sur la figure 4 sont superposés, par exemple les détecteurs $d_1$ et $d_2$, sont ajoutés soit de façon analogique à la sortie des multiplexeurs, soit par le calcul après mise en mémoire.

Selon l'invention, il n'est pas nécessaire comme dans l'art antérieur que la couche semi-réfléchissante 6 ait une transmission rigoureusement égale à sa réflexion puis qu'on somme les signaux réfléchis et transmis. On peut donc utiliser une couche multidiélectrique sans absorption et retrouver après addition des signaux réfléchis et transmis une réponse équivalente à celle d'un détecteur unique.

Le bruit correspondant à chaque point de l'alignement de détecteurs que permet de reconstituer fictivement l'invention est multiplié par $\sqrt{2}$, puisque les deux détecteurs correspondant à chaque point sont sensiblement identiques et que leurs bruits, non corrélés, sont simplement ajoutés quadratiquement.

Selon l'invention, le rapport signal sur bruit est dégradé d'un facteur $\sqrt{2}$ alors qu'il est dégradé d'un facteur 3 à 4 dans le cas du raboutage optique connu de l'art antérieur.

Sur la figure 5, on a représenté l'évolution du rapport signal sur bruit dans le cas de l'aboutement mécanique -trait plein -de l'aboutement optique selon l'art antérieur -trait interrompu et dans le cas de l'aboutement optique selon l'invention -pointillés.

Selon l'invention, le rapport signal sur bruit se situe donc vers 0,7, alors que pour une même technologie de détecteurs il est égal à 1 pour l'aboutement mécanique et à 0,3 pour l'aboutement optique selon l'art antérieur.

Dans le cas d'un détecteur ne fonctionnant pas, que cela provienne d'un défaut de fabrication ou d'un défaut intervenu ultérieurement, l'invention permet d'obtenir un rapport signal sur bruit de 0,5 environ.

Pour les dispositifs d'aboutement connus, dans le cas d'un détecteur ne fonctionnant pas, le rapport signal signal sur bruit est nul, comme cela est illustré par la figure 5.

Selon l'invention, si un détecteur ne fonctionne pas, le détecteur avec lequel il est associé fournira cependant un signal. Le rapport signal sur bruit est alors sensiblement égal à 0,5. Il faut bien entendu ne pas prendre en compte le détecteur ne fonctionnant pas lors de la sommation des signaux.

Cette opération de repérage des détecteurs ne fonctionnant pas ne complique pas sensiblement le fonctionnement du dispositif car il faut savoir que le signal fourni par chaque détecteur est affecté d'un coefficient de correction lié au détecteur, aux défauts du système optique..., et qui impose d'examiner successivement chaque détecteur pour déterminer ce facteur de correction. Au cours de cette opération, on peur déterminer quels détecteurs ne fonctionnent pas.

A la jonction entre deux barrettes, par exemple les barrettes n et n+1, on a représenté sur la figure 5 que, dans le cas de l'aboutement mécanique, il y avait des points manquants, pour lesquels le rapport signal sur bruit est nul et que les points voisins pouvaient être détériorés et présenter un rapport signal sur bruit dégradé.

Dans le cas de l'aboutement optique selon l'art antérieur, il n'y a généralement pas d'altération du rapport signal sur bruit à la jonction de deux barrettes.

Dans le cas de l'invention, à la jonction entre deux barrettes successives, il y a au moins un point qui ne correspond qu'à un seul détecteur.

Ainsi sur la figure 4, le détecteur $d_5$ sera seul à fournir un signal car il correspond à la jonction de deux barrettes portées par l'autre face du système optique.

A la jonction entre deux barrettes puisqu'un seul détecteur est utilisé qui ne reçoit que la moitié du signal, le rapport signal sur bruit est sensiblement de l'ordre de 0,5.

Dans le cas de détecteurs infra-rouge du type BLIP-background limited infra-red photo-detector -il n'y a pratiquement pas augmentation du bruit du fait qu'il faut sommer les signaux provenant de deux détecteurs car le bruit provient du rayonnement reçu et non des détecteurs eux-mêmes.

Le rapport signal sur bruit est donc sensiblement égal à 1.

Il est bien entendu que l'invention est utilisable si l'on veut reconstituer plusieurs lignes de détecteurs, et non pas une seule ligne. Dans ce cas chaque face du système optique utilisé porte plusieurs alignements de barrettes de détecteurs. Le dispositif d'aboutement optique selon l'invention est donc applicable à toutes sortes de mosaïques de détecteurs mono ou bi-dimensionnelles.

**Revendications**

1. Dispositif d'aboutement optique de détecteurs photosensibles (d), disposés sous forme de barrettes, comportant deux prismes (4, 5) accolés par une face semi-réfléchissante (6), les détecteurs étant disposés sur deux faces à angles droit, appartenant chacune à un prisme, caractérisé en ce que:

-il y a au moins un alignement de barrettes sur chacune des faces, ces barrettes étant aussi proches que possible l'une de l'autre et disposées de façon telle que la jonction de deux barrettes sur l'une des faces ne correspond pas à la jonction de deux barrettes sur l'autre face;

-des moyens assurent la sommation des informations en provenance de deux détecteurs $(d_3, d_4)$, situés sur chacune des deux faces, et ayant reçu le même signal.

2. Dispositif selon la revendication 1, caractérisé en ce que chacune des deux dites faces porte plusieurs alignements de barrettes de détecteurs.

3. Dispositif selon l'une des revendications 1 ou 2, caractérisé en ce que des moyens, constitués par un dispositif à transfert de charge comportant un multiplexeur, assurent la lecture séquentielle de chaque détecteur.

4. Dispositif selon la revendication 3, caractérisé en ce que les moyens assurant la sommation des informations en provenance de deux détecteurs réalisent cette sommation de façon analogique à la sortie des multiplexeurs des moyens de lecture.

5. Dispositif selon l'une des revendications 1 à 4, caractérisé en ce que les moyens assurant la sommation des informations en provenance de deux détecteurs réalisent cette sommation par le calcul après mise en mémoire.

# FIG_1

# FIG_2

# FIG_3

# FIG_4

# FIG_5

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | PATENTS ABSTRACTS OF JAPAN, vol. 6, no. 251 (E-147)[1129], 10 décembre 1982; & JP - A - 57 150 273 (MATSUSHITA DENSOU KIKI K.K.) 17-09-1982 <br> * Résumé * | 1,2 | H 04 N 1/12 <br> H 01 L 25/04 |
| | --- | | |
| Y | US-A-4 249 217 (E. KORTE et al.) <br> * Colonne 5, ligne 49 - colonne 7, ligne 30; figures 2,3 * | 1,2 | |
| A | | 3-5 | |
| | --- | | |
| A | US-A-3 955 048 (M. TANABE) <br> * En entier * | 1,2 | |
| | --- | | DOMAINES TECHNIQUES RECHERCHES (Int. Cl.4) |
| A | US-A-4 200 788 (M. A. AGULNEK) <br> * Revendications * | 3-5 | |
| | --- | | H 04 N <br> H 01 L |
| A | US-A-4 272 684 (M. SEACHMAN) <br> * Revendications * | 1,2 | |
| | --- | | |
| A | US-A-4 459 619 (T. YOSHIDA) <br> * Revendications * | 1 | |
| | --- | | |
| A | EP-A-0 091 798 (IBM) <br> * Résumé * | 1-5 | |
| | --- -/- | | |

Le présent rapport de recherche a été établi pour toutes les revendications

| Lieu de la recherche | Date d'achèvement de la recherche | Examinateur |
|---|---|---|
| LA HAYE | 07-07-1986 | GALLO G. |

| | | Page 2 |
|---|---|---|

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | PATENTS ABSTRACTS OF JAPAN, vol. 5, no. 78 (E-58)[750], 22 mai 1981; & JP - A - 56 25 868 (CANON K.K.) 12-03-1981 * Résumé * | 1 | |
| | ----- | | |
| | | | DOMAINES TECHNIQUES RECHERCHES (Int. Cl.4) |

Le présent rapport de recherche a été établi pour toutes les revendications

| Lieu de la recherche | Date d'achèvement de la recherche | Examinateur |
|---|---|---|
| LA HAYE | 07-07-1986 | GALLO G. |